# EUROPEAN PATENT APPLICATION

(11) **EP 2 007 184 A2**
(43) Date of publication of application: **24.12.2008**
(21) Application number: 08157713.2
(22) Date of filing: 06.06.2008
(51) Int. Cl.: H05K 7/20

(54) **System for integrated thermal management and method for the same**

(30) Priority: 18.06.2007 US 764495
(71) Applicant: GENERAL ELECTRIC COMPANY, Schenectady, NY 12345 (US)
(72) Inventor: Roesner, Robert, D-80797, Munich (DE); Teichmann, Ralph, Albany, NY 12210 (US); Delmerico, Robert William, Clifton Park, NY 12065 (US)
(74) Representative: Bedford, Grant Richard

(57) **Abstract**

An integrated thermal management system (10) is provided. The system (10) includes a first device (12) configured to release a first heat loss and coupled to an integrated cooling system (18). The system (10) also includes at least a second device (14) configured to release a second heat loss and coupled to the integrated cooling system (18). The system (10) also includes at least one heat exchanger (20) configured to release the first heat loss and the second heat loss to ambient.

## Description

The invention relates generally to thermal management systems and more specifically, to thermal management in electrical systems.

An electrical system in a commonly used application such as a wind turbine includes electrical components such as transformers, switch gear, power converters and electric machines that are located inside a confined compartment or a containment such as a tower or a nacelle or an external building. Transformers, power converters and electric machines are typically large scale equipment and generate undesirable amount of losses. The losses are released as heat during operation. The transformer and the power converters are usually in close proximity to each other. Further, the power rating of the electric equipment is determined by the ability to homogeneously cool it. Hence, it is desirable to remove the heat from the containment to avoid excessive heating of the electrical components leading to a failure.

In general, there are several techniques used for heat removal from electrical components. A certain technique includes a forced convection device such as a fan. However, a forced convection system generally requires large air ducts and filters for the entry of cool air and to expel hot air from the tower. In addition, a fan may generate undesirable levels of noise and cooling fins add to the size and weight of equipment. Another cooling system typically used includes, but is not limited to, a liquid cooled system. The liquid cooled system enables reducing the size of the electrical system by eliminating large air ducts and cooling fins.

Currently, independent cooling concepts are commonly used to remove the heat from the electrical components in the electrical system. A typical electrical system may include several electrical components having different cooling methods. An example is a forced air cooled transformer and a water cooled power converter system. Therefore, having independent and different cooling system for each of the electrical components adds to size of an electrical system and cost of design.

Hence, there is a need for an improved thermal management system that addresses the aforementioned issues.

In accordance with one aspect of the present invention, an integrated thermal management system is provided. The system includes a first device configured to release a first heat loss and coupled to an integrated cooling system. The system also includes at least a second device configured to release a second heat loss and coupled to the integrated cooling system. The system further includes at least one heat exchanger configured to release the first heat loss and the second heat loss to ambient.

In accordance with another aspect of the invention, a method for integrating thermal management in a heat releasing system is provided. The method includes disposing a first device configured to release a first heat loss. The method also includes separating a second device configured to release a second heat loss from the first device by a heat exchanger. The method further includes extracting heat from the first device and the second device via the heat exchanger.

In accordance with another aspect of the invention, a compact transformer-power converter assembly is provided. The assembly includes a transformer immersed in oil. The transformer also includes a cooling fluid circulating through a power converter system and configured to extract heat from the power converter system and the oil.

Various features, aspects, and advantages of the present invention will become better understood when the following detailed description is read with reference to the accompanying drawings in which like characters represent like parts throughout the drawings, wherein:
FIG. 1 is a block diagram representation of an integrated thermal management system in accordance with an embodiment of the invention;
FIG. 2 is a schematic illustration of an integrated thermal management system used in a wind turbine in accordance with an embodiment of the invention;
FIG. 3 is a schematic illustration of another exemplary integrated thermal management system including a common cooling fluid used in a wind turbine in accordance with an embodiment of the invention;
FIG. 4 is a schematic illustration of another exemplary integrated thermal management system including a third device and a common cooling fluid used in a wind turbine in accordance with an embodiment of the invention; and
FIG. 5 is a flow chart representing steps involved in an exemplary method for integrating thermal management in accordance with an embodiment of the invention.

As discussed in detail below, certain embodiments of the invention include a system for integrated thermal management and a method for the same. The system for integrated thermal management provides an integrated cooling concept via a common cooling medium for electrical components in an electrical generating system for renewable energy such as, but not limited to, a wind turbine. The system also provides a compact assembly of the electrical components.

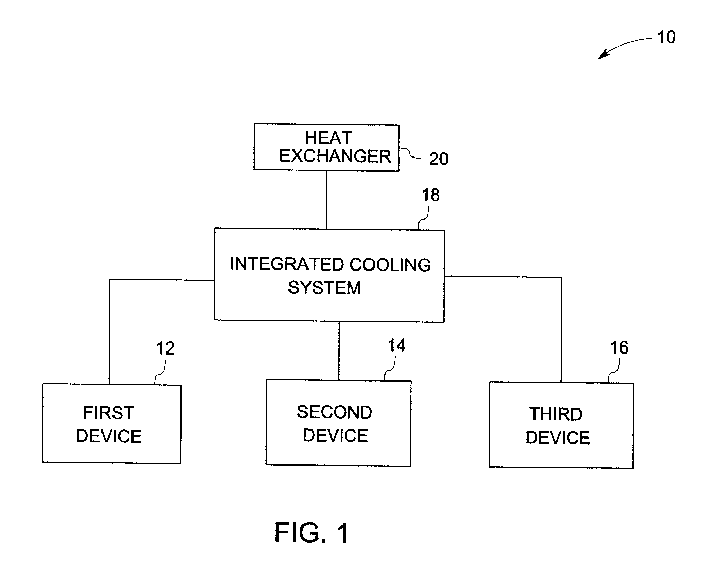

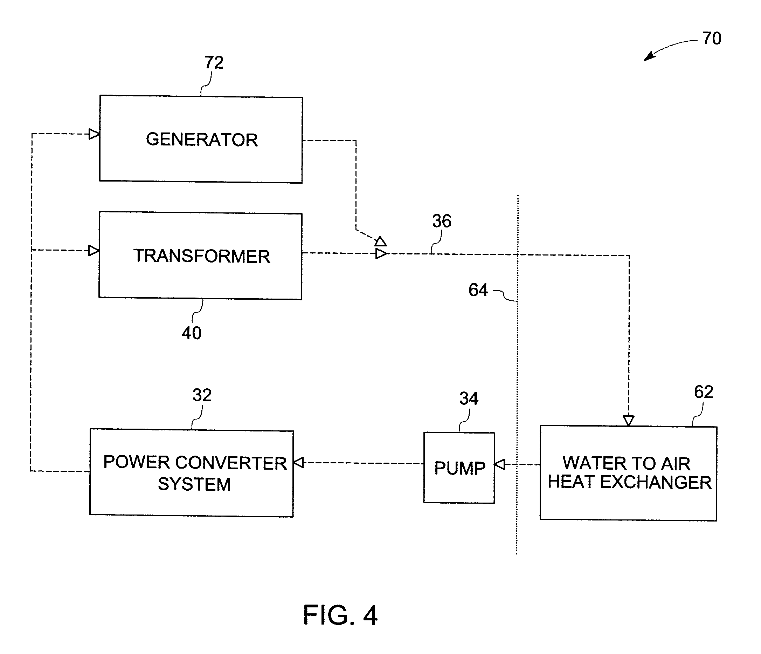

Turning to the drawings, FIG. 1 is a block diagram representation of an integrated thermal management system 10. The thermal management system 10 includes a first device 12 configured to release a first heat loss. A second device 14 is configured to release a second heat loss coupled to an integrated cooling system 18 along with the first device 12. In a presently contemplated embodiment, the system 10 may include a third device 16 releasing a third heat loss. In another embodiment, the system 10 may include two or more devices releasing respective heat losses. In yet another embodiment, the integrated cooling system 18 includes a heat exchanger 20 that separates the first device 12 from the second device 14. In a non-limiting example, the first device 12 includes a power converter system, the second device 14 includes a transformer system and the third device 16 includes a gearbox or a generator. In another embodiment, the integrated cooling system 18 includes a first cooling fluid circulated through the first device 12, a second cooling fluid circulated through the second device 14 and a third cooling fluid circulated through the third device 16 via a pump. A heat exchanger 20 is coupled to the integrated cooling system 18 to extract heat from the first cooling fluid, the second cooling fluid and the third cooling fluid. The heat exchanger 20 may be installed inside or outside a containment such as, but not limited to, the wind turbine tower or nacelle. In an exemplary embodiment, the system 10 may include a common cooling fluid for the first device 12, the second device 14 and the third device 16 as described in FIG. 4.

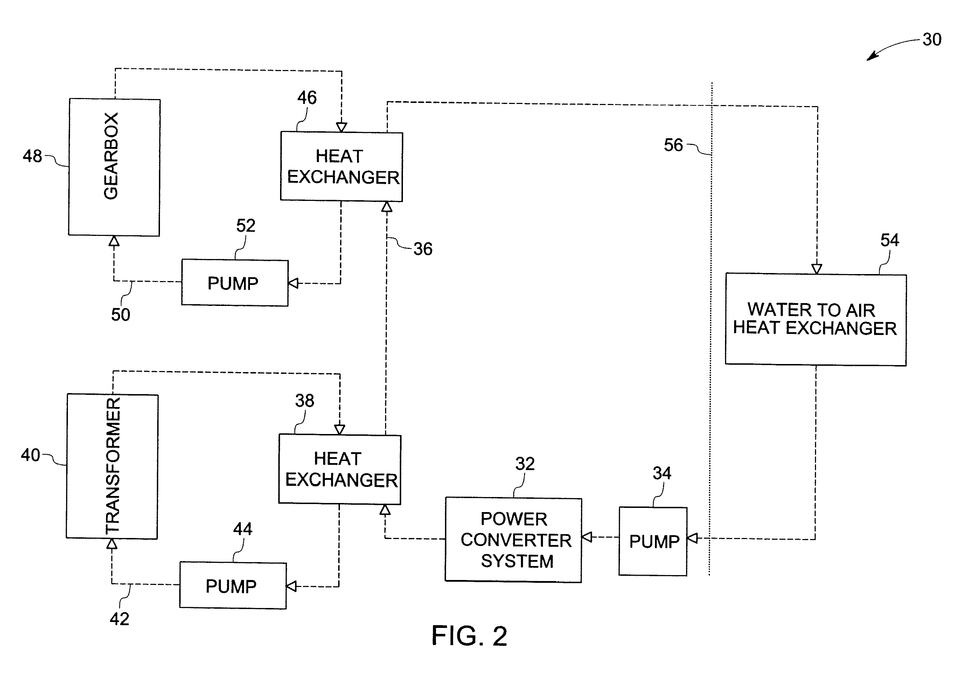

FIG. 2 is a schematic illustration of an integrated thermal management system 30 employed in an application such as, but not limited to, a wind turbine. The system 30 includes a power converter system 32 coupled with a pump 34 to provide a first cooling fluid 36. In a particular embodiment, the first cooling fluid 36 is water. The first cooling fluid 36 is in contact with a heat exchanger 38 coupled to a transformer 40 immersed in a second cooling fluid 42. In a particular embodiment, the second cooling fluid 42 is oil. A pump 44 circulates the second cooling fluid 42 within the transformer 40. The heat exchanger 38 extracts heat from the second cooling fluid 42 to the first cooling fluid 36. In a particular embodiment, temperature of the first cooling fluid 36 may be about 60°C and the temperature of the second cooling fluid 40 may be between about 70°C and about 80°C providing a differential in temperature of at least about 10°C. Typically, the outlet temperature of the cooling fluid 36 at the power converter system 32 will be low enough to be the inlet temperature of the second cooling fluid 42. Similarly, the first cooling fluid 36 is also in contact with a heat exchanger 46 coupled to a third device such as, but not limited to, a gearbox 48 immersed in a third cooling fluid 50. In a particular embodiment, the third cooling fluid 50 is oil. A pump 52 circulates the third cooling fluid 50 within the gearbox 48. The heat exchanger 46 extracts heat from the third cooling fluid 50 to the first cooling fluid 36. A heat exchanger 54 is installed outside a wind turbine tower 56 or a nacelle that encloses the thermal management system 30. In a particular embodiment, the heat exchanger 54 employs natural convection. In another embodiment, the heat exchanger 54 employs forced convection using a device such as, but not limited to, a fan. The heat exchanger 54 extracts heat from the first cooling fluid 36 into the ambient. In another embodiment the integrated thermal management system 30 is installed inside a wind turbine nacelle.

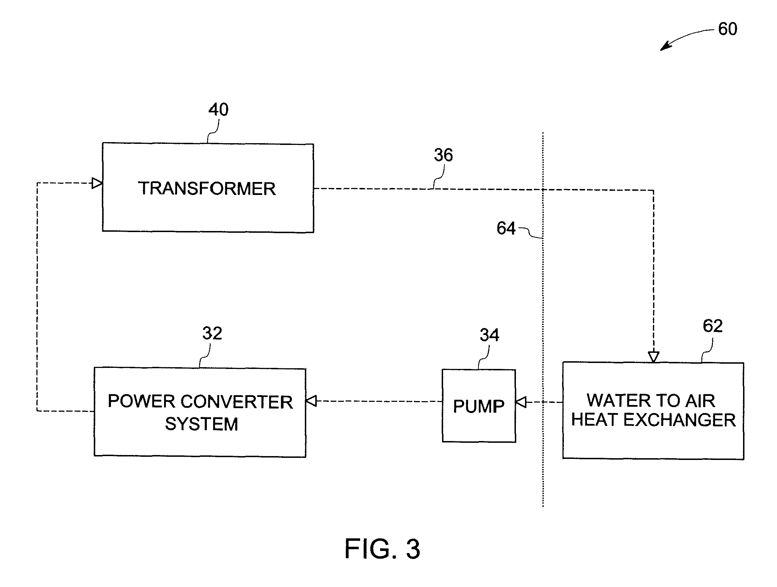

FIG. 3 is a schematic illustration of another exemplary integrated thermal management system 60 employed in an application such as, but not limited to, a wind turbine. The system 60 includes a power converter system 32 as referenced in FIG. 2 coupled with a pump 34 to circulate a first cooling fluid 36 as referenced in FIG. 2. The first cooling fluid 36 is in direct contact with the transformer 40 in FIG. 2. In the presently contemplated embodiment, the first cooling fluid 36 is circulated through the power converter system 32 and the transformer 40 to extract heat from both the devices. A heat exchanger 62 is installed outside a wind turbine tower 64 or a nacelle that encloses the thermal management system 60 and extracts heat from the first cooling fluid 36 to the ambient. In a particular embodiment, the heat exchanger 62 employs natural or free convection. In another embodiment, the heat exchanger 62 employs forced convection using a device such as, but not limited to, a fan. In yet another embodiment the integrated thermal management system is installed inside a wind turbine nacelle.

In a particular embodiment, the system 60 may include various electrical components that may be cooled as described above. Further, the electrical components are typically physically placed close to each other and thus facilitate integrated cooling. The system 60 also increases packaging density of the electrical components and enables for a single piece, factory assembled and tested unit. The system 60 reduces number of parts in an assembly and therefore increases reliability of the system.

FIG. 4 is a schematic illustration of another exemplary integrated thermal management system 70 including three devices employed in an application such as, but not limited to, a wind turbine. Further to the embodiment described in FIG. 3, the thermal management system 70 includes an additional third device 72 in contact with the first cooling fluid 36. In a non-limiting example, the third device 72 includes a generator. In the illustrated embodiment, cooling of the generator 72 is connected in parallel to the second device 40. In another embodiment, cooling of the generator 72 may be connected in series to the transformer 40. The first cooling fluid 36 extracts heat from the power converter system 32, the transformer 40 and the generator 72. A heat exchanger 62 as referenced in FIG. 3 extracts heat from the first cooling fluid 36 to the ambient. In an embodiment, the heat exchanger 62 is installed outside a wind turbine tower 64 or a nacelle. In another embodiment, the heat exchanger 62 may be installed inside the wind turbine tower 64.

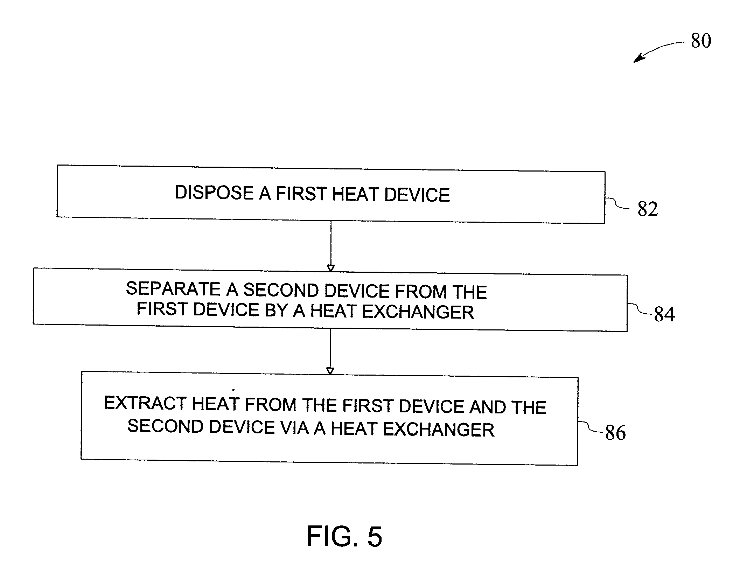

FIG. 5 is a flow chart representing exemplary steps in a method 80 for integrating thermal management in a heat generating system. The method 80 includes disposing a first device configured to release a first heat loss in step 82. A second device is separated from the first device by a heat exchanger in step 84. Heat from the first device and the second device is extracted via the heat exchanger in step 86. In a particular embodiment, the heat is extracted via forced convective cooling by circulating a cooling fluid through the second device. In another embodiment, the heat is extracted by circulating a cooling fluid through the first device via a pump. In yet another embodiment, the heat extracted is at least about 80 percent of heat generated in the first heat generating device and the second heat device.

The various embodiments of a system for integrated thermal management and a method for the same described above thus provide a way to achieve convenient and efficient means for removal of heat from electrical components. These techniques and systems also allow for highly compact and efficient wind turbine systems due to improved heat removal system and improved packaging density.

Of course, it is to be understood that not necessarily all such objects or advantages described above may be achieved in accordance with any particular embodiment. Thus, for example, those skilled in the art will recognize that the systems and techniques described herein may be embodied or carried out in a manner that achieves or optimizes one advantage or group of advantages as taught herein without necessarily achieving other objects or advantages as may be taught or suggested herein.

Furthermore, the skilled artisan will recognize the interchangeability of various features from different embodiments. For example, the use of a transformer as a second device with respect to one embodiment can be adapted for use with a third device such as, but not limited to a generator or a gearbox described with respect to another. Similarly, the various features described, as well as other known equivalents for each feature, can be mixed and matched by one of ordinary skill in this art to construct additional systems and techniques in accordance with principles of this disclosure.

While only certain features of the invention have been illustrated and described herein, modifications and changes will occur to those skilled in the art. It is, therefore, to be understood that the appended claims are intended to cover all such modifications and changes as fall within the true spirit of the invention.

## Claims

1. An integrated thermal management system (10) comprising:
a first device (12) configured to release a first heat loss and coupled to an integrated cooling system (18);
at least a second device (14) configured to release a second heat loss and coupled to the integrated cooling system (18); and
at least one heat exchanger (20) configured to release the first heat loss and the second heat loss to ambient.

2. The system (10) of claim 1, wherein the integrated cooling system (18) comprises:
a first cooling fluid (36) circulating through the first device (12) via a first pump (34) and coupled to a first heat exchanger (38); and
a second cooling fluid (42) circulating through the second device (14) via a second pump (44) and coupled to a second heat exchanger (46).

3. The system (10) of any preceding claim, further comprising at least a third device (16) configured to release a third heat loss.

4. The system (10) of claim 2 or claim 3, wherein the integrated cooling system (18) comprises the first cooling fluid (36) circulating through the first device (12) and the second device (14) and coupled to the first heat exchanger (38).

5. The system (10) of any preceding claim, wherein the first device (12) and the second device (14) are connected in parallel or series.

6. A method (80) of integrating thermal management in a heat releasing system comprising:
disposing (82) a first device configured to release a first heat loss;
separating (84) a second device configured to release a second heat loss from the first device by a heat exchanger; and
extracting (86) heat from the first device and the second device via the heat exchanger.

7. The method (80) of claim 6, wherein the extracting (86) heat comprises circulating a second cooling fluid through the second device via a pump.

8. The method (80) of claim 6 or claim 7, wherein the extracting (86) heat comprises circulating a second cooling fluid via forced or free convection.

9. A compact transformer-power converter assembly (30) comprising:
a transformer (40) immersed in oil; and
a cooling fluid (36) circulating through a power converter system (32) and configured to extract heat from the power converter system (32) and the oil.

10. The assembly (30) of claim 9, further comprising a first heat exchanger (38) to extract heat from the oil to the cooling fluid (36).
